(19) Europäisches Patentamt
European Patent Office
Office européen des brevets

(11) EP 1 306 686 A2

(12) # EUROPEAN PATENT APPLICATION

(43) Date of publication:
02.05.2003 Bulletin 2003/18

(51) Int Cl.[7]: G01R 31/36

(21) Application number: 02257346.3

(22) Date of filing: 23.10.2002

(84) Designated Contracting States:
AT BE BG CH CY CZ DE DK EE ES FI FR GB GR IE IT LI LU MC NL PT SE SK TR
Designated Extension States:
AL LT LV MK RO SI

(30) Priority: 23.10.2001 US 336848 P

(71) Applicant: Wilson Greatbatch Technologies, Inc.
Clarence, New York 14031 (US)

(72) Inventor: Freitag, Gary
East Aurora, New York 14052 (US)

(74) Representative: Colmer, Stephen Gary et al
Mathys & Squire
100 Gray's Inn Road
London WC1X 8AL (GB)

(54) **Method for determining poor performing cells**

(57) A means for determining long-term discharge performance, particularly in a lithium/silver vanadium oxide cell, by analyzing and characterizing the initial pulse voltage waveform, is described. The relationship between the initial P1 ($P_{min}$) voltage drop and the extent of that initial voltage drop with $P_{last}$ (the final voltage under load) is a reliable indication of long-term discharge performance.

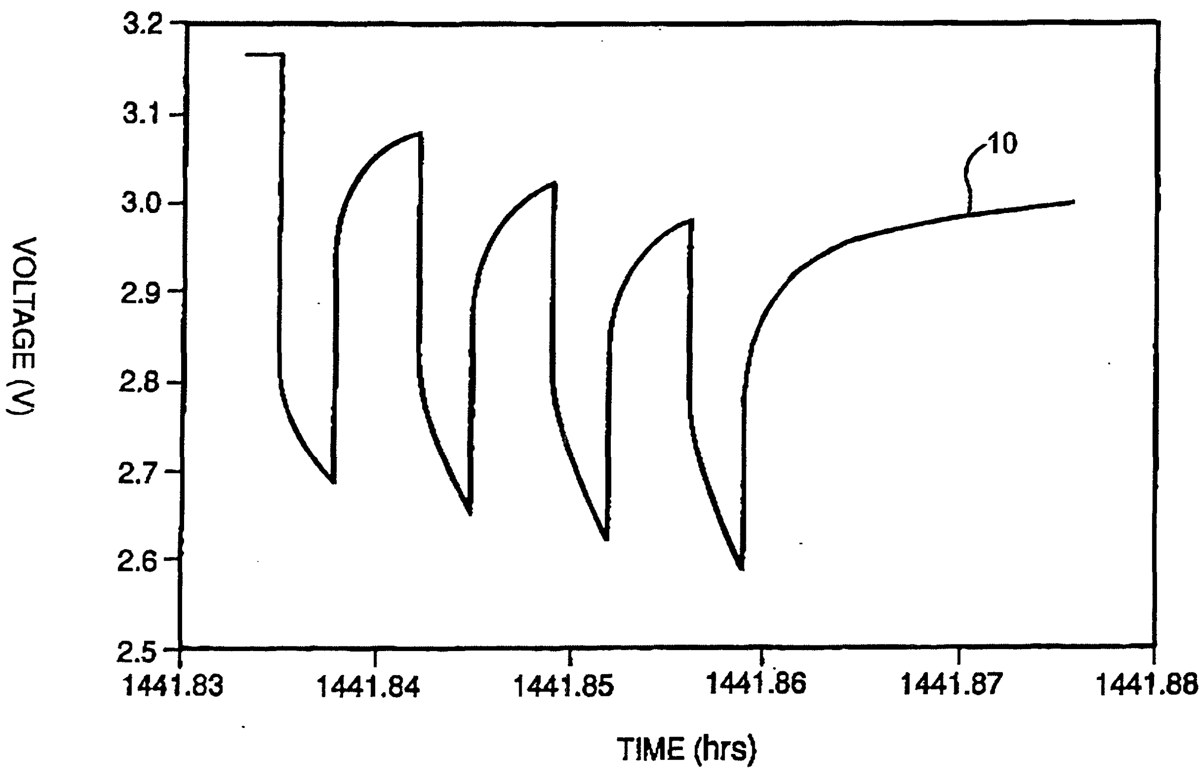


FIG. 1

EP 1 306 686 A2

## Description

BACKGROUND OF THE INVENTION

1. Field of the Invention

The present invention generally relates to an alkali metal electrochemical cell, and more particularly, to a lithium cell suitable for current pulse discharge applications. More particularly, the present invention characterizes the shape of the first pulse during cell burn-in discharge or otherwise, to predict long-term performance. A particularly preferred electrochemical couple is a lithium/silver vanadium oxide cell (Li/SVO). The discharge characterization is especially important in the transition between the first and second voltage plateaus of a Li/SVO cell discharge where voltage delay typically occurs.

2. Prior Art

Efforts have been made to determine long-term performance of a cell at beginning of life to use as a means of screening out poor performers, problem solve root causes to various performance issues, or to determine and identify the impact of certain factors or changes in components or processes. Conventional methods include subjecting the cells to elevated temperature storage or Arrhenius type accelerations, or comparison of individual cell burn-in data to the general population. However, with elevated temperature type tests, the nature of the test introduces unknown or undefined reactions that may invalidate the correlation. Also, these tests often take months to produce a relationship and cannot be used for screening purposes. Comparison of individual burn-in data to the general population can be used as a screen for gross performance issues, but is unable to differentiate between poor and good performers under long-term discharge, especially in the voltage delay region typically seen with SVO chemistry.

Prior work also shows a lack of correlation between an initial pulse minimum voltage ($P_{min}$) or open current voltage (OCV) values and long-term performance. Many factors contribute to variation in burn-in results which confound and prevent developing a definitive link between initial and long-term performance. Higher initial pulse voltages do not necessarily indicate better long-term performance.

Therefore, there is a need for a test that is relatively easy to administer and evaluate and that differentiates between cells prone to experiencing unacceptable voltage delay and those that will not.

SUMMARY OF THE INVENTION

Voltage delay is a phenomenon typically exhibited in an alkali metal/mixed metal oxide cell, and particularly, a Li/SVO cell that has been depleted of about 40% to 70% of its capacity and is being subjected to current pulse discharge applications. This is predominantly during the first and second voltage plateaus typical of a Li/SVO discharge. The voltage response of a cell that does not exhibit voltage delay during the application of a short duration pulse or pulse train has distinct features. First, the cell potential decreases throughout the application of the pulse until it reaches a minimum at the end of the pulse, and second, the minimum potential of the first pulse in a series of pulses is higher than the minimum potential of the last pulse. FIG. 1 is a graph showing an illustrative discharge curve 10 as a typical or "ideal" response of a cell during the application of a series of pulses as a pulse train that does not exhibit voltage delay.

The voltage response of a cell that does exhibit voltage delay during the application of a short duration pulse or during a pulse train can take one or both of two forms. One form is that the leading edge potential of the first pulse is lower than the end edge potential of the first pulse. In other words, the voltage of the cell at the instant the first pulse is applied is lower than the voltage of the cell immediately before the first pulse is removed. The second form of voltage delay is that the minimum potential of the first pulse is lower than the minimum potential of the last pulse when a series of pulses have been applied. FIG. 2 is a graph showing an illustrative discharge curve 12 as the voltage response of a cell that exhibits both forms of voltage delay.

The initial drop in cell potential during the application of a short duration pulse reflects the resistance of the cell, i.e., the resistance due to the cathode, anode, electrolyte, surface films and polarization. In the absence of voltage delay, the resistance due to passivated films on the anode and/or cathode is negligible. In other words, the drop in potential between the background voltage and the lowest voltage under pulse discharge conditions, excluding voltage delay, is an indication of the conductivity of the cell, i.e., the conductivity of the cathode, anode, electrolyte, and surface films, while the gradual decrease in cell potential during the application of the pulse train is due to the polarization of the electrodes and the electrolyte.

The present invention provides a means of determining long-term performance by analyzing and characterizing the initial pulse voltage waveform to determine whether a particular cell has unacceptable levels of passivation at the anode and cathode interfaces with the electrolyte. It can be shown that the relationship between the initial P1 ($P_{min}$) voltage drop and the extent of that initial voltage drop with $P_{last}$ (the final voltage under load) is a reliable indication of long-term discharge performance.

## BRIEF DESCRIPTION OF THE DRAWINGS

FIG. 1 is a graph showing an illustrative pulse discharge curve 10 of an exemplary electrochemical cell that does not exhibit voltage delay.

FIG. 2 is a graph showing an illustrative pulse discharge curve 12 of an exemplary electrochemical cell that exhibits voltage delay.

FIG. 3 is a block diagram and flow chart illustrating the steps involved in manufacturing a cathode component from a free-standing sheet of cathode active material for use in an electrochemical cell.

FIG. 4 is a graph showing the results of the calculation of $P_{last}$ - $P_{min}$ for a plurality of Li/SVO cells after having been pulse discharged.

FIGs. 5 and 6 illustrate the average pulse discharge results of a plurality of Li/SVO cells under different discharge regimes.

## DETAILED DESCRIPTION OF THE PREFERRED EMBODIMENTS

An electrochemical cell according to the present invention includes an anode electrode selected from Group IA of the Periodic Table of Elements, including lithium, sodium, potassium, etc., and their alloys and intermetallic compounds including, for example Li-Si, Li-B and Li-Si-B alloys and intermetallic compounds. The preferred anode comprises lithium, and the more preferred anode comprises a lithium alloy, the preferred lithium alloy being lithium-aluminum with the aluminum comprising from between about 0% to about 50% by weight of the alloy. The greater the amounts of aluminum present by weight in the alloy, however, the lower the energy density of the cell.

The form of the anode may vary, but preferably it is a thin metal sheet or foil of the anode metal pressed or rolled on a metallic anode current collector, i.e., preferably comprising nickel, to form an anode component. In the exemplary cell of the present invention, the anode component has an extended tab or lead of the same material as the anode current collector, i.e., preferably nickel, integrally formed therewith, such as by welding and contacted by a weld to a cell case of conductive metal in a case-negative electrical configuration. Alternatively, the anode may be formed in some other geometry, such as a bobbin shape, cylinder or pellet to allow an alternate low surface cell design.

The cathode material comprises a mixed metal oxide formed by chemical addition, reaction or otherwise intimate contact or by a thermal spray coating process of various metal sulfides, metal oxides or metal oxide/elemental metal combinations.

By way of illustration, and in no way intended to be limiting, an exemplary cathode active material comprises silver vanadium oxide having the general formula $Ag_xV_2O_y$ in any one of its many phases, i.e. β-phase silver vanadium oxide having in the general formula x = 0.35 and y = 5.18, γ-phase silver vanadium oxide having in the general formula x = 0.74 and y = 5.37 and ε-phase silver vanadium oxide having in the general formula x = 1.0 and y = 5.5, and combinations and mixtures of phases thereof.

Another preferred composite transition metal oxide cathode material includes $V_2O_z$ wherein $z \leq 5$ combined with $Ag_2O$ having silver in either the silver(II), silver(I) or silver(0) oxidation state and CuO with copper in either the copper(II), copper(I) or copper(0) oxidation state to provide the mixed metal oxide having the general formula $Cu_xAg_yV_2O_z$, (CSVO). Thus, the composite cathode active material may be described as a metal oxide-metal oxide-metal oxide, a metal-metal oxide-metal oxide, or a metal-metal-metal oxide and the range of material compositions found for $Cu_xAg_yV_2O_z$ is preferably about $0.01 \leq z \leq 6.5$. Typical forms of CSVO are $Cu_{0.16}Ag_{0.67}V_2O_z$ with z being about 5.5 and $Cu_{0.5}Ag_{0.5}V_2O_z$ with z being about 5.75. The oxygen content is designated by z since the exact stoichiometric proportion of oxygen in CSVO varies depending on whether the cathode material is prepared in an oxidizing atmosphere such as air or oxygen, or in an inert atmosphere such as argon, nitrogen and helium. For a more detailed description of this cathode active material, reference is made to U.S. Patent Nos. 5,472,810 to Takeuchi et al. and 5,516,340 to Takeuchi et al., both of which are assigned to the assignee of the present invention and incorporated herein by reference.

Other suitable cathode materials include copper vanadium oxide, manganese dioxide, titanium disulfide, copper oxide, copper sulfide, iron sulfide, and iron disulfide. Carbon and fluorinated carbon are also useful cathode active materials. The solid cathode exhibits excellent thermal stability and is generally safer and less reactive than a non-solid cathode.

Such cathode active materials are formed into a cathode electrode with the aid of a binder material. Suitable binders are powdered fluoro-polymers; more preferably powdered polytetrafluoroethylene or powdered polyvinylidene fluoride. Further, up to about 10 weight percent of a conductive diluent is preferably added to the cathode mixture to improve conductivity. Suitable materials for this purpose include acetylene black, carbon black and/or graphite or a metallic powder such as powdered nickel, aluminum, titanium and stainless steel. The preferred cathode active mixture thus includes a powdered fluoro-polymer binder present at about 1 to 5 weight percent, a conductive diluent present at about 1 to 5 weight percent and about 90 to 98 weight percent of the cathode active material.

The cathode electrode is formed either by rolling, spreading or pressing the cathode active mixture onto a suitable current collector. Another preferred method for building a cathode electrode is to press a free-standing sheet of the active mixture to a current collector. This method is illustrated in the block diagram flow chart of FIG. 3 and begins by taking granular cathode active material and adjusting its particle size to a useful range. This is done by comminuting the cathode material in attrition or grinding step 20. A ball mill or vertical ball mill is preferred and typical grinding times range from between about 10 to 15 minutes. The finely divided cathode material is preferably mixed with one of the above-described conductive diluents and binder materials to form a depolarizer cathode admixture in the step designated 22. Preferably, the admixture comprises about 3 weight percent of the conductive diluents and about 3 weight percent of the binder material. This is typically done in a solvent of either water or an inert organic medium such as mineral spirits. The mixing process provides for the fibrillation of the fluoro-resin to ensure material integrity. In some cases, no electronic conductor material or binder is required and the percent cathode active material is preferably held between about 80 percent to about 99 percent. After mixing sufficiently to ensure homogeneity in the admixture, the cathode admixture is removed from the mixer as a paste.

The admixture paste is then fed into a series of roll mills that compact the cathode material into a thin sheet having a tape form, or the cathode admixture first is run through a briquette mill in the step designated 24. In the latter case, the cathode admixture is formed into small pellets that are then fed into the roll mills.

Typically, the compacting step 26 is performed by two to four calendar mills that serve to press the admixture between rotating rollers to provide a free-standing sheet of the cathode material as a continuous tape. The cathode tape preferably has a thickness in the range of from about 0.004 inches to about 0.020 inches. The outer edges of the tape leaving the rollers are trimmed and wound up on a take-up reel, as indicated at 28, to form a roll of the cathode material that is subsequently subjected to a drying step 30 under vacuum conditions. The drying step removes any residual solvent and/or water from the cathode material. Alternatively, the process includes drop wise addition of liquid electrolyte into the cathode mixture prior to rolling to enhance the performance and rate capacity of an assembled electrochemical cell incorporating the cathode material.

After drying, the cathode material is unwound and fed on a conveyor belt, as shown at 32, and moved to a punching machine. The punching operation 34 forms the continuous tape of cathode material into any dimension needed for preparation of the cathode component.

As shown in FIG. 3, the method contains several feedback loops that serve to recycle the cathode active material should the quality control not be up to an acceptable level. This contributes to the process yield, as very little cathode material is lost to waste. After the cathode admixture is pressed during step 26 by the series of calendar mills, if the resulting tape is too thin or otherwise of insufficient quality, the tape is sent to a recycler, indicated as step 36 that reintroduces the cathode material into the feed line entering the calendar mills. If needed, the solvent concentration is adjusted during step 38 as needed, to provide a more uniform consistency to the cathode admixture paste for rolling into the cathode tape. This first recycle step 36 is also useful for reintroducing trimmings and similar leftover cathode material back into the feed line entering the calendar mills.

A second recycle loop removes the cathode material from the process after the punching operation 34 and feeds back into the calendar mills 26 through the recycler indicated in step 36 and the briquette mill in step 24, if that latter step is included in the process, as previously discussed. Again, the solvent concentration is adjusted during step 38 to produce a paste that is suitable for rolling into a tape of uniform cross-sectional thickness.

As previously discussed, upon completion of the drying step 30, the tape of cathode material is sent to the punching operation 34. The punching operation serves to cut the sheet material into cathode plates having a variety of shapes including strips, half-round shapes, rectangular shapes, oblong pieces, or others, that are moved during step 40 to a pressing station for fabrication of the cathode electrode. For a more detailed description of the pressing operation, reference is made to U.S. Patent Nos. 5,435,874 and 5,571,640, both to Takeuchi et al. These patents are assigned to the assignee of the present invention and incorporated herein by reference.

Cathodes prepared as described above may be in the form of one or more plates operatively associated with at least one or more plates of anode material. Alternatively, the cathode may be in the form of a strip wound with a corresponding strip of anode material in a structure similar to a "jellyroll".

The cell of the present invention includes a separator to provide physical separation between the anode and cathode active electrodes. The separator is of electrically insulative material to prevent an internal electrical short circuit between the electrodes, and the separator material also is chemically unreactive with the anode and cathode active materials and both chemically unreactive with and insoluble in the electrolyte. In addition, the separator material has a degree of porosity sufficient to allow flow there through of the electrolyte during the electrochemical reaction of the cell. Illustrative separator materials include non-woven glass, polypropylene, polyethylene, glass fiber material, ceramics, a polytetrafluorethylene membrane commercially available under the designations ZITEX (Chemplast Inc.), a polypropylene membrane commercially available under the designation CELGARD (Celanese Plastic Company Inc.) and DEXIGLAS (C. H. Dexter, Div., Dexter Corp.).

The form of the separator typically is a sheet that is placed between the anode and cathode electrodes and in a manner preventing physical contact between them. Such is the case when the anode is folded in a serpentine-like structure with a plurality of cathode plates disposed intermediate the anode folds and received in a cell casing or when the electrode combination is rolled or otherwise formed into a cylindrical "jellyroll" or flat folded configuration.

The electrochemical cell of the present invention further includes a nonaqueous, ionically conductive electrolyte that serves as a medium for migration of ions between the anode and the cathode during the electrochemical reactions of the cell. The electrochemical reaction at the cathode involves conversion of ions that migrate from the anode to the cathode in atomic or molecular forms. A suitable electrolyte has an inorganic, ionically conductive salt dissolved in a nonaqueous solvent. More preferably, the electrolyte includes an ionizable alkali metal salt dissolved in a mixture of aprotic organic solvents comprising a low viscosity solvent and a high permittivity solvent. The inorganic, ionically conductive salt serves as the vehicle for migration of the anode ions to intercalate or react with the cathode active materials. Preferably, the ion forming alkali metal salt is similar to the alkali metal comprising the anode. In the case of an anode comprising lithium, the electrolyte salt is selected from $LiPF_6$, $LiBF_4$, $LiAsF_6$, $LiSbF_6$, $LiClO_4$, $LiO_2$, $LiAlCl_4$, $LiGaCl_4$, $LiC(SO_2CF_3)_3$, $LiN(SO_2CF_3)_2$, LiSCN, $LiO_3SCF_3$, $LiC_6F_5SO_3$, $LiO_2CCF_3$, $LiSO_6F$, $LiB(C_6H_5)_4$, $LiCF_3SO_3$, and mixtures thereof.

Low viscosity solvents useful with the present invention include esters, linear and cyclic ethers and dialkyl carbonates such as tetrahydrofuran (THF), methyl acetate (MA), diglyme, trigylme, tetragylme, dimethyl carbonate (DMC), 1,2-dimethoxyethane (DME), 1,2-diethoxyethane (DEE), 1-ethoxy,2-methoxyethane (EME), ethyl methyl carbonate (EMC), methyl propyl carbonate, ethyl propyl carbonate, diethyl carbonate (DEC), dipropyl carbonate, and mixtures thereof. High permittivity solvents include cyclic carbonates, cyclic esters and cyclic amides such as propylene carbonate (PC), ethylene carbonate (EC), butylene carbonate, acetonitrile, dimethyl sulfoxide, dimethyl formamide, dimethyl acetamide, γ-valerolactone, γ-butyrolactone (GBL), N-methyl-pyrrolidinone (NMP), and mixtures thereof. In the present invention, the preferred anode active material is lithium metal and the preferred electrolyte is 0.8M to 1.5M $LiAsF_6$ or $LiPF_6$ dissolved in a 50:50 mixture, by volume, of propylene carbonate and 1,2-dimethoxyethane.

The assembly of the cell described herein is preferably in the form of a wound element cell. That is, the fabricated cathode, anode and separator are wound together in a "jellyroll" type configuration or "wound element cell stack" such that the anode is on the outside of the roll to make electrical contact with the cell case in a case-negative configuration. Using top and bottom insulators, the wound cell stack is inserted into a metallic case of a suitable size dimension. The metallic case may comprise materials such as stainless steel, mild steel, nickel-plated mild steel, titanium or aluminum, but not limited thereto, so long as the metallic material is compatible for use with components of the cell.

The cell header comprises a metallic disc-shaped or rectangular-shaped body with a first hole to accommodate a glass-to-metal seal/terminal pin feedthrough and a second hole for electrolyte filling. The glass used is of a corrosion resistant type having from between about 0% to about 50% by weight silicon such as CABAL 12, TA 23, FUSITE 425 or FUSITE 435. The positive terminal pin feedthrough preferably comprises titanium although molybdenum, aluminum, nickel alloy, or stainless steel can also be used. The cell header comprises elements having compatibility with the other components of the electrochemical cell and is resistant to corrosion. The cathode lead is welded to the positive terminal pin in the glass-to-metal seal and the header is welded to the case containing the electrode stack. The cell is thereafter filled with the electrolyte solution described hereinabove and hermetically sealed such as by close-welding a stainless steel disc or ball over the fill hole, but not limited thereto. This above assembly describes a case-negative cell that is the preferred construction of the exemplary cell of the present invention. As is well known to those skilled in the art, the electrochemical system of the present invention can also be constructed in a case-positive configuration.

Cells built according to the present invention are particularly well suited for powering implantable medical devices such as cardiac pacemakers, defibrillators, neuro-stimulators and drug pumps. For example, an implantable cardiac defibrillator is a device that requires a power source for a generally medium rate, constant resistance load component provided by circuits performing functions such as the heart sensing and pacing functions. This is a medical device monitoring function that requires electrical current of about 1 microampere to about 100 milliamperes. From time-to-time, the cardiac defibrillator may require a generally high rate, pulse discharge load component that occurs, for example, during charging of a capacitor in the defibrillator for the purpose of delivering an electrical shock to the heart to treat tachyarrhythmias, the irregular, rapid heartbeats that can be fatal if left uncorrected. This medical device operating function requires a significantly greater electrical current than the monitoring function of about 1 ampere to about 4 amperes.

As used herein, the term "pulse" means a short burst of electrical current of significantly greater amplitude than that of a pre-pulse current immediately prior to the pulse. A pulse train consists of at least two pulses of electrical current delivered in relatively short succession with or without open circuit rest between the pulses. An exemplary pulse train may consist of four 10-second pulses (23.2 mA/$cm^2$) with a 15 second rest between each pulse. A typically used range of current densities for cells powering implantable medical devices is from about 15 mA/$cm^2$ to about 50 mA/$cm^2$, and more preferably from about 18 mA/$cm^2$ to about 35 mA/$cm^2$. Typically, a 10 second pulse is suitable for medical implantable applications. However, it could be significantly shorter or longer depending on the specific cell design and chemistry.

Particularly during the medical device operating function, it is important that the cell experience as little voltage delay as possible. Charge time is the key important performance parameter for implantable defibrillators since increasing the length of time necessary to convert the heart back to its normal function decreases the chance of success. A certain amount of energy must be extracted from the battery per charge. The rate at which this occurs is a function of the loaded voltage. The higher the loaded voltage the faster energy can be extracted, and therefore, the shorter the charge time.

The energy needed, Q, is a function of loaded voltage and current load by the following relationship:

$$Q = V \times I \times t$$

where t is the time necessary to extract a given Q. For a typical pulse discharge application, Q = 60 Joules and I = 2.0 Amps. Under these conditions, every 0.130 V drop in loaded voltage represents an additional 1-second in charge time. Thus, according to the present invention, when the calculation of $P_{last} \sim P_{min}$ is less than about 20 mA/$cm^2$ between a first and second pulse-discharged cells, there is no significant difference in their discharge performance. On the other hand, when the calculation of $P_{last}$ - $P_{min}$ is greater than about 20 mA/$cm^2$ between the two cells under pulse discharge conditions, there is a significant difference in their discharge performance. In other words, a difference of 20 mA/$cm^2$ is a significant increase from one cell to the next. Also, in general, the closer the calculation of $P_{last}$ - $P_{min}$ is to zero, the better a particular cell will perform in relative terms.

The following examples describe the manner and process of an electrochemical cell according to the present invention, and set forth the best mode contemplated by the inventors of carrying out the invention.

EXAMPLE I

Tests cells were constructed having a lithium anode and a cathode comprising silver vanadium oxide activated with an organic electrolyte. The cell design utilized a cathode in the form of a sheet manufactured according to the previously referenced U.S. Patent Nos. 5,435,874 and 5,571,640, both to Takeuchi et al. The cathode mixture consisted of, by weight, 94% SVO cathode active material, along with 3% of a PTFE powder, 2% graphite, and 1% carbon black. The sheet was pressed onto an expanded metal current collector, and encapsulated in a polypropylene separator. The anode of each cell was a strip of metallic lithium pressed onto a nickel current collector and also encapsulated in a polypropylene separator. The polypropylene separator for both the anode and the cathode was a 0.001" film laminate. The anode was wrapped accordion style around the cathode plates to provide an active electrode surface area of 95.9 $cm^2$. The cells were filled with a 1 M solution of $LiAsF_6$ dissolved in an equal volume mixture of PC and DME as the electrolyte. The cells were hermetically sealed.

The thusly constructed cells underwent a burn-in discharge consisting of the application of four 10-second 2.5 Amp pulses with 15 seconds rest between each pulse. As indicated in Fig. 4, the calculation $P_{last}$ - $P_{min}$ was made and the cells were then divided into Group A cells (square symbols) and Group B cells (star symbols). The conclusion is that, in general, it can be expected that the Group B cells will perform better under pulse discharge than the Group A cells.

EXAMPLE II

Twelve of the cells from Example I were then discharged under loads of 17.4 KΩ. Six cells from each group were then subjected to a 12 month accelerated discharge data (ADD) regime consisting of a pulse train comprising four 2.5 A, 10 second pulses (26.1 mA/$cm^2$) with 15 seconds rest between each pulse. One such pulse train was superimposed on the background load every 30 days. The 12-month ADD is designed to deplete the cells of 100% of their theoretical capacity in 12 months.

The results are presented in FIG. 5 where curve 50 was constructed from the average background voltage of the Group A cells, curve 52 was constructed from the average pulse 1 minima voltage, curve 54 was constructed from the average of the average voltage throughout the ten second pulse and curve 56 was constructed from the average pulse 4 minima voltage. In comparison, curve 60 was constructed from the average background voltage of the Group B cells, curve 62 is of the average pulse 1 minima voltage, curve 64 is of the average of the average voltage throughout the ten second pulse and curve 66 is of the average pulse 4 minima voltage.

EXAMPLE III

Six additional cells from each group in Example I were subjected to a 1-year ADD regime consisting of a pulse train comprising four 2.5 A, 10 second pulses (26.1 mA/$cm^2$) with 15 seconds rest between each pulse. One such pulse train was superimposed on the background load each 2 months. The 1-year ADD is designed to deplete the cells of 70% of their theoretical capacity in one year. The results are presented in FIG. 6 where curve 70 was constructed from the average background voltage of the Group A cells, curve 72 was constructed from the average pulse 1 minima voltage, curve 74 was constructed from the average of the average voltage throughout the ten second pulse and curve 76 was constructed from the average pulse 4 minima voltage. In comparison, curve 80 was constructed from the average background voltage of the Group B cells, curve 82 is of the average pulse 1 minima voltage, curve 84 is of the average of the average voltage throughout the ten second pulse and curve 86 is of the average pulse 4 minima voltage.

In each discharge regime, a significant separation is evident between the two groups of cells at middle of life even though initially the Group A cells slightly outperformed the Group B cells. The causes of voltage delay within the initial pulse may be specific or widespread, and may be due to: oxidation or other resistances developed on the anode or cathode, or the current collectors, moisture content within the cell, or residual solvents remaining from the processing of the SVO.

It is appreciated that various modifications to the inventive concepts described herein may be apparent to those of ordinary skill in the art without departing from the spirit and scope of the present invention as defined by the appended claims.

## Claims

**1.** A method of testing a cell comprising a lithium-containing anode and a cathode of an active material selected from the group consisting of silver vanadium oxide, copper silver vanadium oxide, copper vanadium oxide, manganese dioxide, titanium disulfide, copper oxide, copper sulfide, iron sulfide, iron disulfide, carbon, fluorinated carbon, and mixtures thereof activated with a nonaqueous electrolyte; comprising the steps of:

(a) discharging the cell to deliver a burst of electrical current of significantly greater amplitude than that of a pre-pulse current immediately prior to the pulse;
(b) recording a pulse minimum voltage ($P_{min}$) and the extend of the $P_{min}$ with a final voltage ($P_{last}$)during the pulse discharge;
(c) calculating $P_{last}$ - $P_{min}$ for the cell;
(d) comparing the result of the calculation with data derived from carrying out steps (a), (b) and (c) on a reference cell; and
(e) determining on the basis of the comparison (d) whether the cell will experience increased voltage delay under current pulse discharge.

**2.** A method according to Claim 1 wherein said determination (e) is carried out by assessing whether the difference between the $P_{last}$ - $P_{min}$ voltage calculated in step (c) and $P_{last}$ - $P_{min}$ data derived from carrying out steps (a), (b) and (c) on a reference cell is less than or greater than 20 mV.

**3.** A method for determining whether a first cell will experience increased voltage delay under current pulse discharge in comparison to a second cell, comprising the steps of:

(a) providing the first and second cells comprising a lithium-containing anode and a cathode of an active material selected from the group consisting of silver vanadium oxide, copper silver vanadium oxide, copper vanadium oxide, manganese dioxide, titanium disulfide, copper oxide, copper sulfide, iron sulfide, iron disulfide, carbon, fluorinated carbon, and mixtures thereof activated with a nonaqueous electrolyte;
(b) discharging the first and second cells to deliver a burst of electrical current of significantly greater amplitude than that of a pre-pulse current immediately prior to the pulse;
(c) recording a pulse minimum voltage ($P_{min}$) and the extent of the $P_{min}$ with a final voltage ($P_{last}$) during the pulse discharge; and
(d) calculating $P_{last}$ - $P_{min}$ for the first cell and then for the second cell, wherein when the difference between the result of the calculation for the first cell and the result of the calculation for the second cell is less than about 20 mV, there is no significant difference in the voltage delay performance between the first and second cells and wherein when the difference is greater than about 20 mV, there is a significant difference in the voltage delay performance between the first and second cells.

**4.** A method for determining whether a first cell will experience increased voltage delay under current pulse discharge in comparison to a second cell, comprising the steps of:

(a) providing the first and second cells comprising a lithium-containing anode and a silver vanadium oxide cathode active material activated with a nonaqueous electrolyte;
(b) discharging the first and second cells to deliver a burst of electrical current of significantly greater amplitude than that of a pre-pulse current immediately prior to the pulse;
(c) recording a pulse minimum voltage ($P_{min}$) and the extend of the $P_{min}$ with a final voltage ($P_{last}$) during the pulse discharge; and
(d) calculating $P_{last}$ - $P_{min}$ for the first cell and then for the second cell, wherein when the difference between the result of the calculation for the first cell and the result of the calculation for the second cell is less than about 20 mV, there is no significant difference in the voltage delay performance between the first and second cells and wherein the difference is greater than about 20 mV, there is a significant difference in the voltage delay performance between the first and second cells.

**5.** A method for determining whether a first cell will experience increased voltage delay under current pulse discharge in comparison to a second cell, comprising the steps of:

(a) providing the first and second cells comprising a lithium-containing anode and a silver vanadium oxide cathode active material activated with a nonaqueous electrolyte, wherein the cathode is formed by mixing the active material with a solvent material to form a paste comprising the cathode active material followed by subjecting the paste to a first pressing step forming the paste into a cathode sheet, then removing any residual solvent material from the cathode sheet, followed by subjecting the cathode sheet to a forming means that serves to provide at least one cathode plate, and then laminating at least one of the thus formed cathode plates on at least one side of a current collector by subjecting the cathode plate to a second pressing step to form a laminated cathode component as the cathode;
(b) discharging the first and second cells to deliver a burst of electrical current of significantly greater amplitude than that of a pre-pulse current immediately prior to the pulse;
(c) recording a pulse minimum voltage ($P_{min}$) and the extent of the $P_{min}$ with a final voltage ($P_{last}$) during the pulse discharge; and
(d) calculating $P_{last}$ - $P_{min}$ for the first cell and then for the second cell, wherein when the difference between the result of the calculation for the difference between the result of the calculation for the first cell and the result of the calculation for the second cell is less than about 20 mV, there is no significant difference in the voltage delay performance between the first and second cells and wherein when the difference is greater than about 20 mV, there is a significant difference in the voltage delay performance between the first and second cells.

**6.** The method of any preceding claim including discharging the cell to deliver at least two pulses of electrical current in a relatively short succession with or without open circuit rest between the pulse.

**7.** The method Claim 6 including discharging the cell to deliver a pulse train consisting of four pulses with a rest period between each pulse.

**8.** The method of Claim 6 or Claim 7 wherein $P_{last}$ and $P_{min}$ are derived from the first pulse of the at least two pulses.

**9.** The method of any of Claims 6 to 8 including providing the rest period being about 15 seconds.

**10.** The method of any preceding claim including providing the pulse of a current density ranging from about 15 $mA/cm^2$ to about 35 $mA/cm^2$.

**11.** The method of Claim 10 including providing the pulse of a current density ranging from about 18 $mA/cm^2$ to about 35 $mA/cm^2$.

**12.** The method of any preceding claim including providing the pulse of about 1 amp to about 4 amps.

**13.** The method of any preceding claim including providing the cathode comprising from between about 80 weight percent to about 99 weight percent of the cathode active material.

**14.** The method of any preceding claim including providing the cathode comprising at least one of a binder material and conductive additives.

**15.** The method of Claim 14 including providing the binder material as a fluoro-resin powder.

**16.** The method of Claim 14 or Claim 15 including selecting the conductive additive from the group consisting of carbon, graphite powder, acetylene black, and mixtures thereof.

**17.** The method of any preceding claim including providing the cathode comprising about 0 to 3 weight percent carbon, about 1 to 5 weight percent of a powder fluoro-resin and about 94 weight percent of the cathode active material.

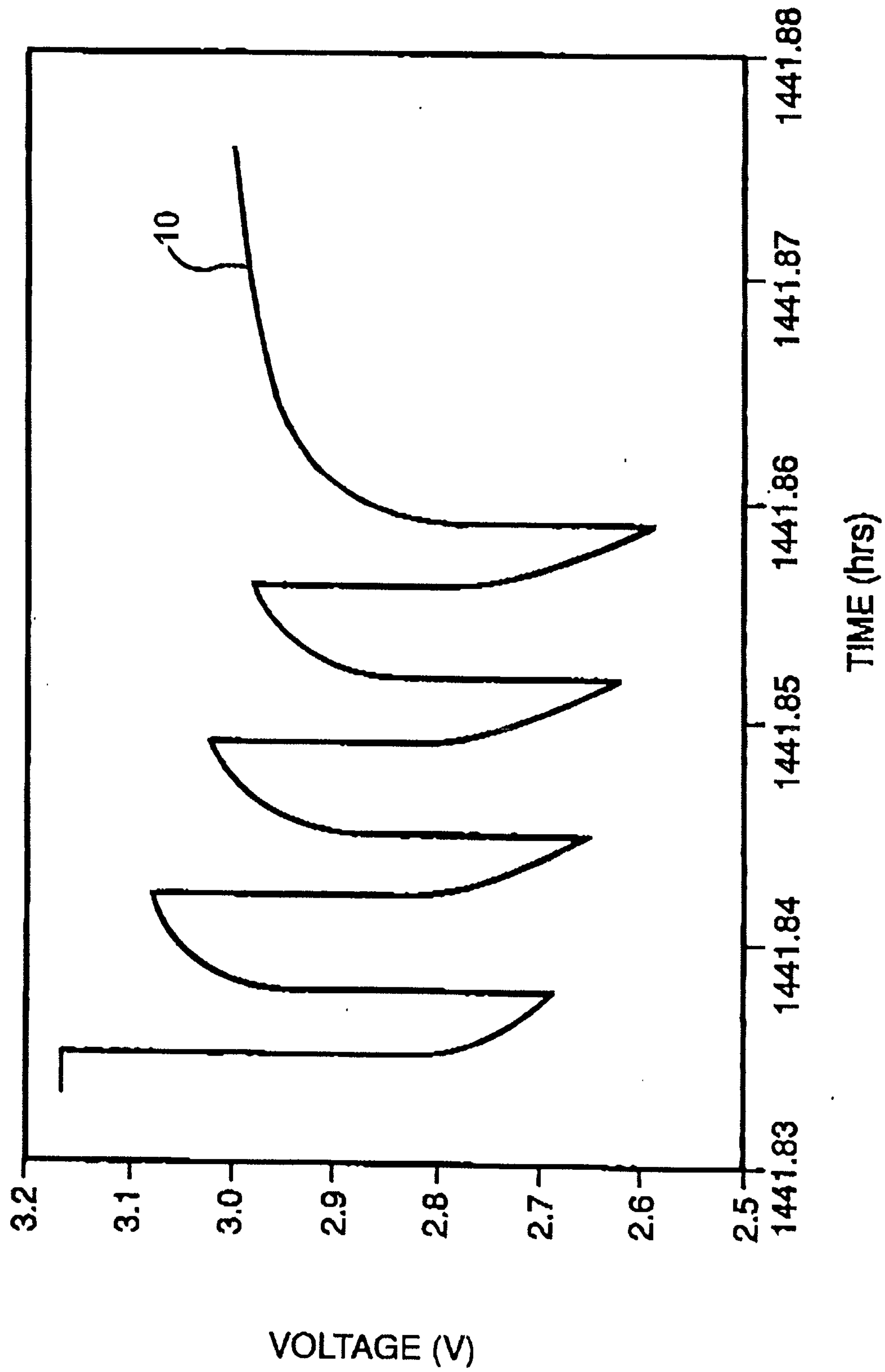
3.2
3.1
3.0
2.9
2.8
2.7
2.6
2.5
1441.83
1441.84
1441.85
1441.86
1441.87
1441.88
10
TIME (hrs)
VOLTAGE (V)

FIG. 1

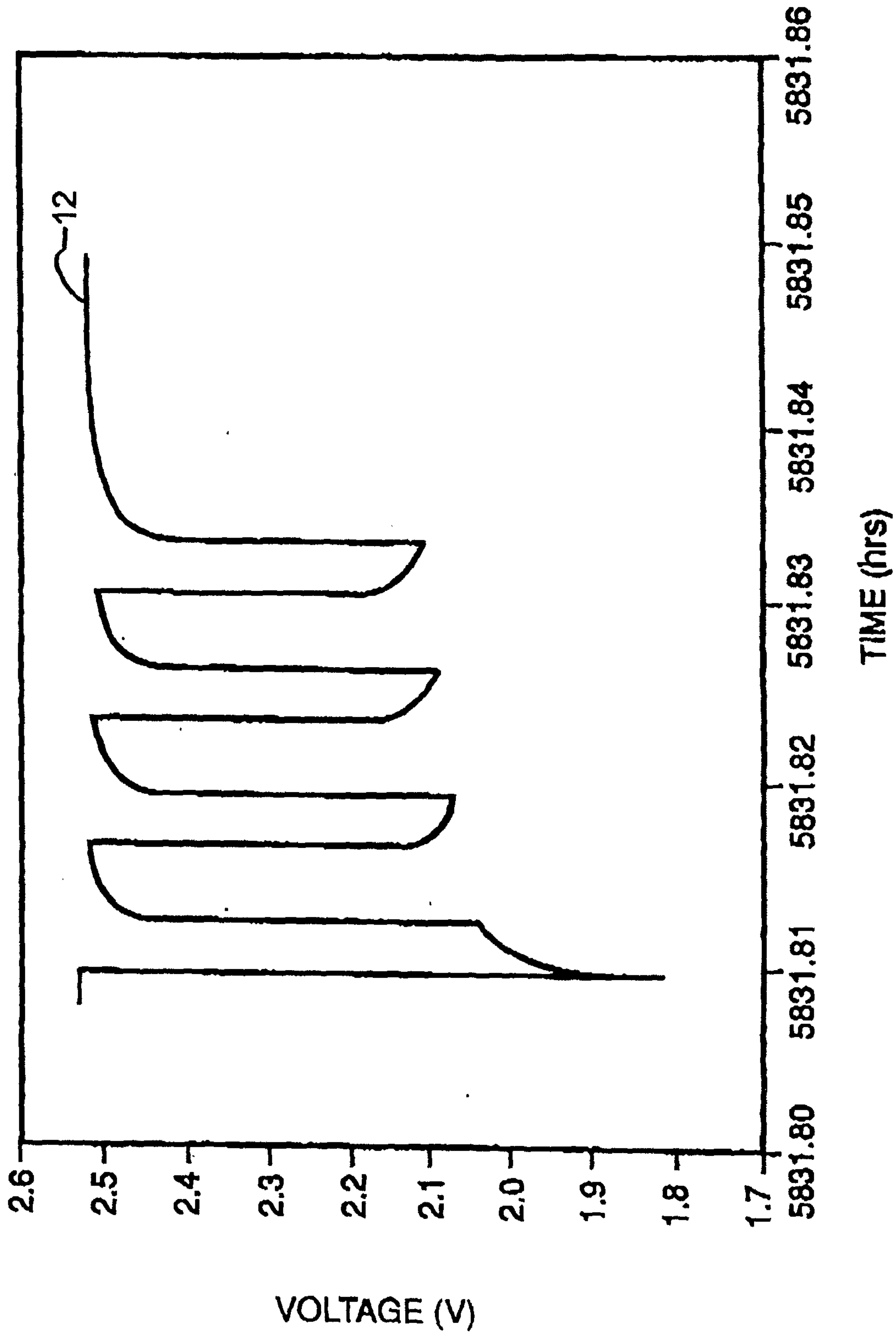
VOLTAGE (V)
2.6
2.5
2.4
2.3
2.2
2.1
2.0
1.9
1.8
1.7
TIME (hrs)
5831.80
5831.81
5831.82
5831.83
5831.84
5831.85
5831.86
12

FIG. 2

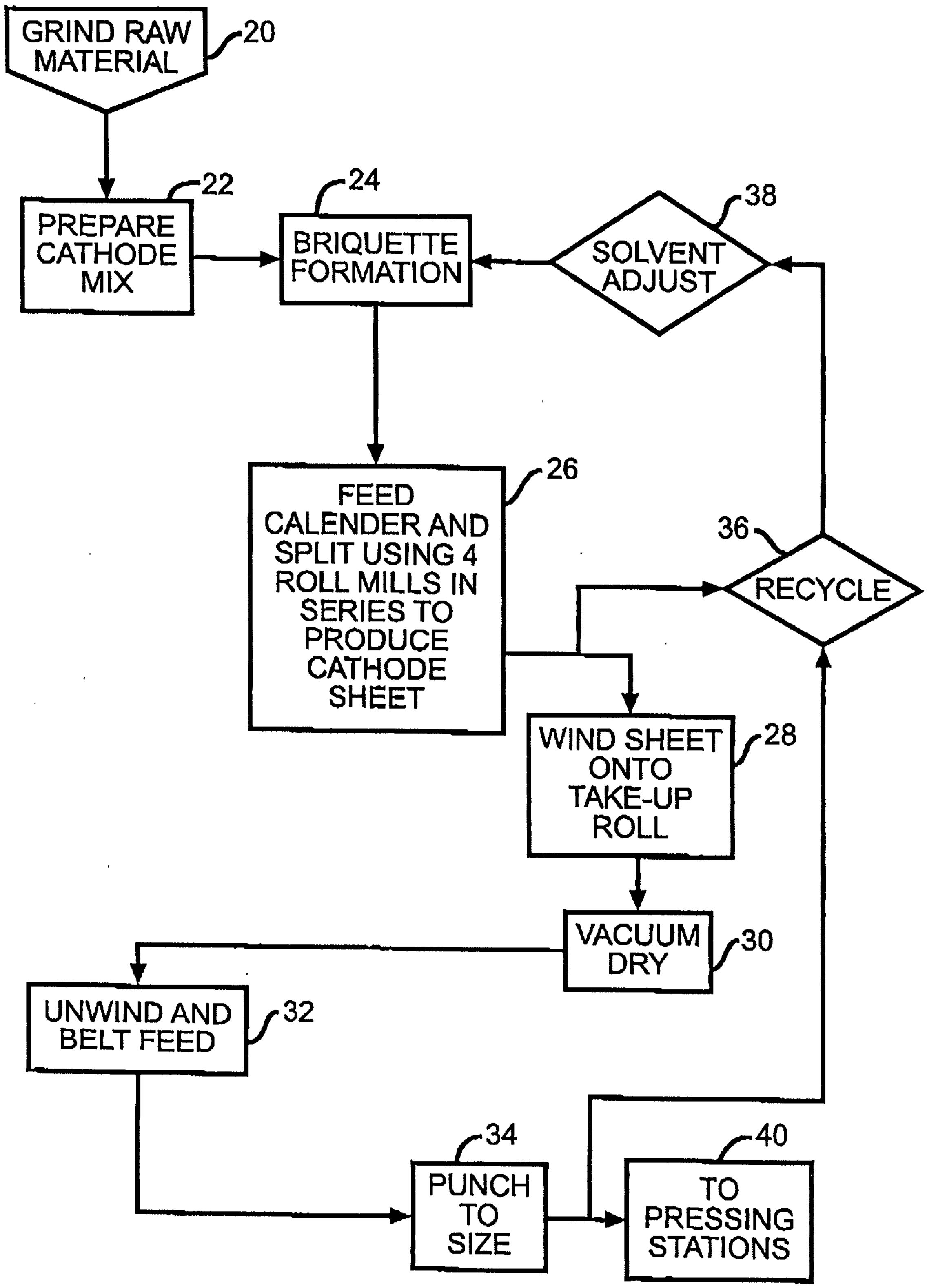
GRIND RAW MATERIAL
20
PREPARE CATHODE MIX
22
BRIQUETTE FORMATION
24
SOLVENT ADJUST
38
FEED CALENDER AND SPLIT USING 4 ROLL MILLS IN SERIES TO PRODUCE CATHODE SHEET
26
RECYCLE
36
WIND SHEET ONTO TAKE-UP ROLL
28
VACUUM DRY
30
UNWIND AND BELT FEED
32
PUNCH TO SIZE
34
TO PRESSING STATIONS
40

FIG. 3

FIG. 4

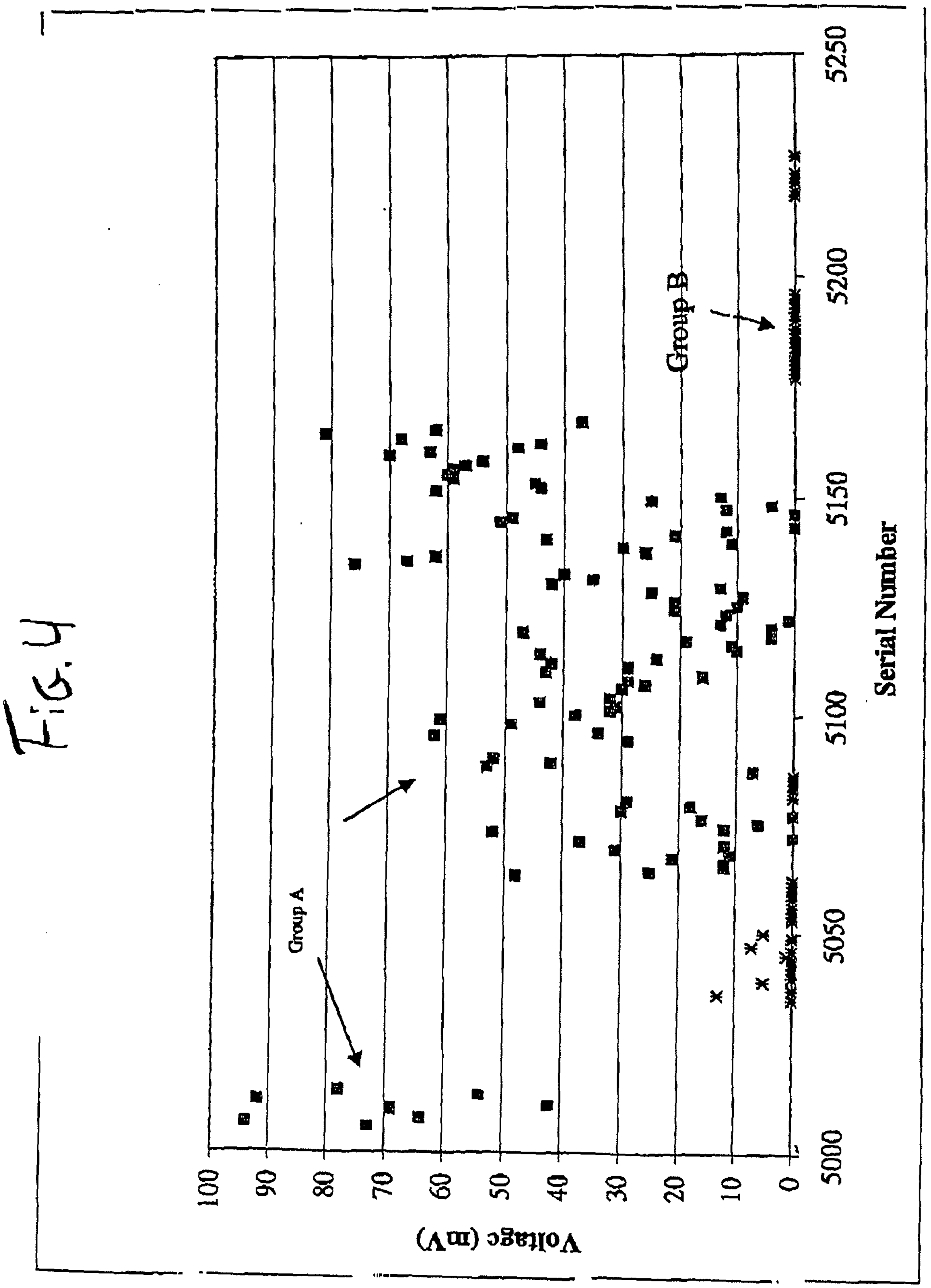
Group A
Group B
Voltage (mV)
Serial Number
100
90
80
70
60
50
40
30
20
10
0
5000
5050
5100
5150
5200
5250

FIG. 5

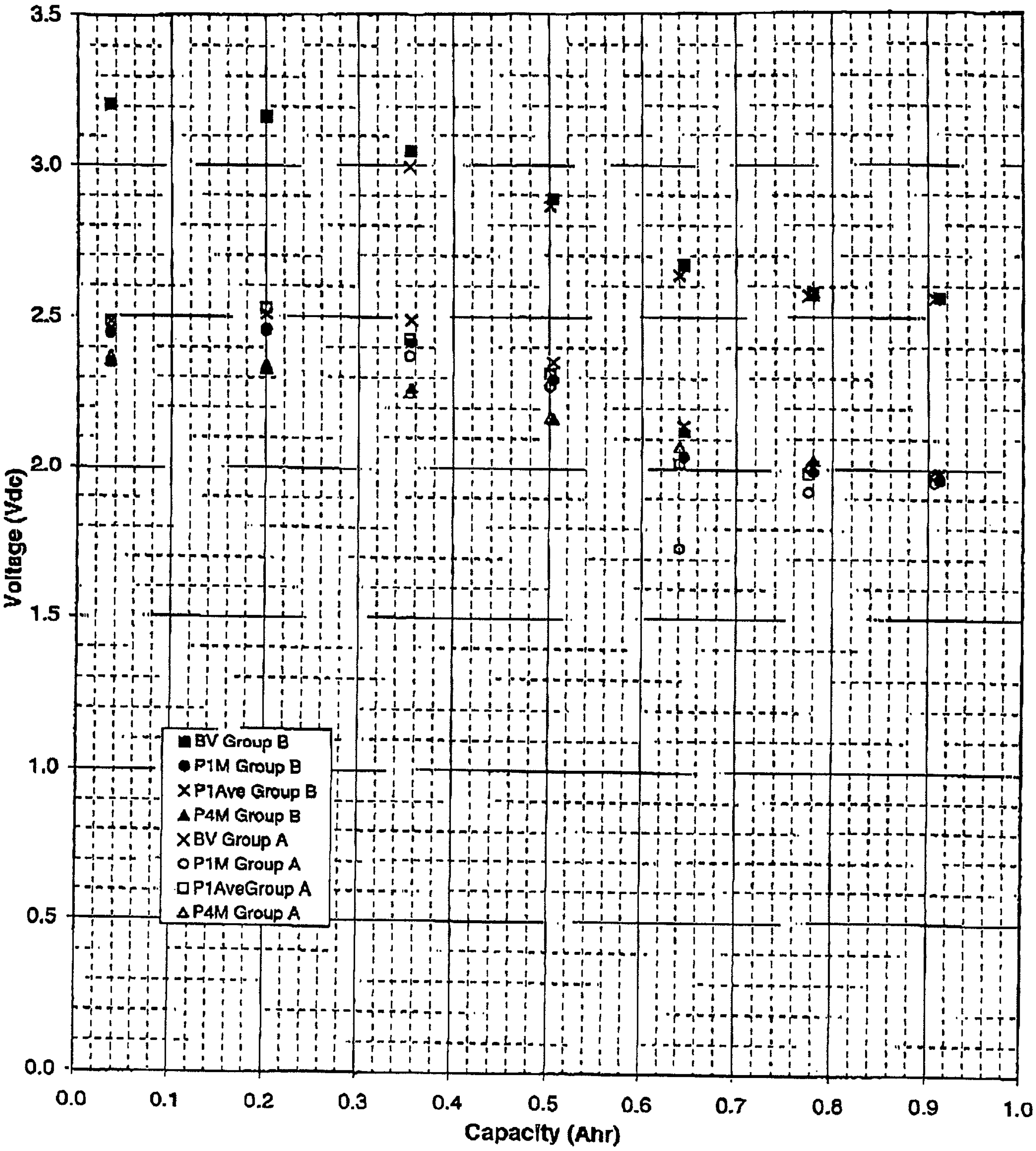
3.5
3.0
2.5
2.0
1.5
1.0
0.5
0.0
Voltage (Vdc)
0.0
0.1
0.2
0.3
0.4
0.5
0.6
0.7
0.8
0.9
1.0
Capacity (Ahr)
BV Group B
P1M Group B
P1Ave Group B
P4M Group B
BV Group A
P1M Group A
P1AveGroup A
P4M Group A

FIG. 6

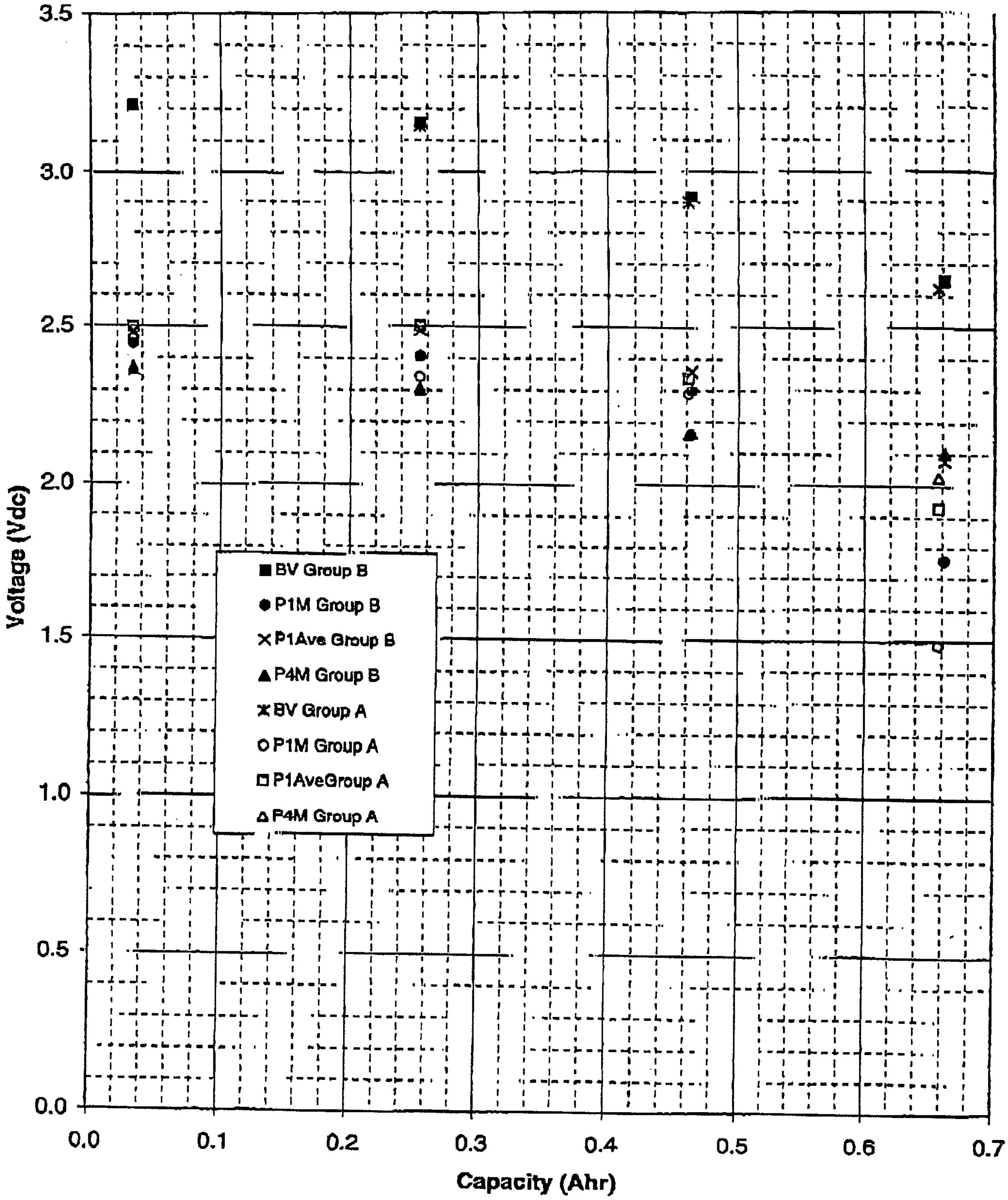
3.5
3.0
2.5
2.0
1.5
1.0
0.5
0.0
Voltage (Vdc)
0.0
0.1
0.2
0.3
0.4
0.5
0.6
0.7
Capacity (Ahr)
BV Group B
P1M Group B
P1Ave Group B
P4M Group B
BV Group A
P1M Group A
P1AveGroup A
P4M Group A